Europäisches Patentamt

European Patent Office

Office européen des brevets

(19)

(11) **EP 1 487 112 A1**

(12) **EUROPEAN PATENT APPLICATION**
published in accordance with Art. 158(3) EPC

(43) Date of publication:
**15.12.2004  Bulletin 2004/51**

(51) Int Cl.⁷: **H03M 7/30**, H04N 7/28

(21) Application number: **03705222.2**

(86) International application number:
**PCT/JP2003/001629**

(22) Date of filing: **17.02.2003**

(87) International publication number:
**WO 2003/071687 (28.08.2003 Gazette 2003/35)**

(84) Designated Contracting States:
**AT BE BG CH CY CZ DE DK EE ES FI FR GB GR
HU IE IT LI LU MC NL PT SE SI SK TR**

(30) Priority:  **20.02.2002  JP 2002044054**

(71) Applicant: **Ohmi, Tadahiro
Sendai-shi, Miyagi 980-0813 (JP)**

(72) Inventors:
• **OHMI, Tadahiro
Aoba-ku, Sendai-shi, Miyagi 980-0813 (JP)**

• **MOCHIZUKI, Kenji,
Tohoku Univety. Dept. of Elect.
Sendai-shi, Miyagi 980-8579 (JP)**
• **KOTANI, Koji, Tohoku Univety. Dept. of Electr.
Sendai-shi, Miyagi 980-8579 (JP)**

(74) Representative: **Glawe. Delfs. Moll
Patentanwälte
Postfach 26 01 62
80058 München (DE)**

(54)  **DATA PROCESSING DEVICE**

(57)    In order to carry out data compression processing using vector quantization at a high speed by hardware, upon retrieving a template pattern most similar to an input pattern from a plurality of template patterns, those template patterns to be subjected to calculation of the degree of similarity are selected by the use of feature quantities of the input pattern and the template patterns. Upon calculating the degree of similarity between each of the selected template patterns and the input pattern, the calculation is carried out in a bit serial fashion. Thus, in pattern matching processing in the vector quantization, the number of the templates to be subjected to matching is reduced and the number of cycles required for calculation upon matching is reduced, thereby enabling the data compression processing using the vector quantization to be carried out at a high speed.

FIG. 1

## EP 1 487 112 A1

**Description**

Technical Field

The present invention relates to a data processing device that compresses data by vector quantization.

Background Art

Heretofore, in the fields of information processing and multimedia, processing called pattern matching has often been used and vector quantization is one of such processing. The vector quantization is a technique used in, for example, data compression processing for image data and sound data. In typical image data compression using the vector quantization, individual image data corresponding to each block of a predetermined size (e.g. 4 × 4 pixels) is extracted from two-dimensionally arrayed image data and treated as a 16-dimensional input vector in case of the block of 4 × 4 pixels. In this case, a plurality of pixel patterns (template vectors) each having the same size as that of the block used in extracting the image data are prepared in advance.

Then, comparison is made between the input vector and each template vector to find out, among these template vectors, the template vector most similar to the input vector. Specifically, distance calculation between input vector data and template vector data is performed for every template vector data. One of the template vectors which gives a minimum distance as a result of the calculation is assumed to have the highest degree of similarity. In this manner, in the vector quantization, image data compression is carried out by quantizing the input vector by the use of the template vectors.

However, in the conventional vector quantization described above, the data compression processing for the image data or the sound data requires a very large amount of calculation. Accordingly, there arises a problem that a long time is required for the compression processing.

As one approach for solving the above-mentioned problem, there is known a method of utilizing feature quantities of vectors to reduce the calculation amount in the vector quantization. In this method, comparison is made between a feature quantity of the input vector and a feature quantity of each of the template vectors obtained in advance. By the use of the result of comparison, the number of those template vectors to be searched (to be subjected to distance calculation) is reduced. In this manner, it is possible to reduce the calculation amount of the distance calculation and the like in the vector quantization and to speed up the vector quantization.

However, in the above-mentioned method of utilizing the feature quantities of the vectors to reduce the calculation amount, there is a problem that, when plural kinds of feature quantities are used, feature quantity storage memories and feature quantity comparison circuits are increased in number, resulting in an increase in hardware scale required to realize the processing of the vector quantization. On the other hand, there is another problem that, when the number of kinds of the feature quantities is reduced on the contrary, the reduction of the calculation amount in the vector quantization becomes small and a high reduction effect of calculation cannot be obtained.

As another approach of solving the problem that a long time is required for the compression processing by the vector quantization, there is known a method of decreasing the number of steps required for distance calculation in the vector quantization by performing the distance calculation from an upper digit. In this method, upon realizing the processing of vector quantization by hardware, a calculation circuit supplied with input data from an upper digit and producing output data from an upper digit is provided as a circuit for calculating a distance between input vector data and template vector data. Thus, update judgment about the minimum distance based on the distance calculation is carried out successively from the upper digit and, at the time instant when it is judged that the minimum distance is not updated, the distance calculation can be stopped. Therefore, it is possible to reduce the number of the steps required for the distance calculation in the vector quantization to thereby speed up the vector quantization.

However, in the above-mentioned method of reducing the number of the steps required for the distance calculation in the vector quantization, search of the template vector data is carried out for all the template vector data. Therefore, even if the input vector data and the template vector data have patterns obviously different from each other, the distance calculation is executed (started) and a large amount of useless calculation is inevitably executed.

The present invention has been accomplished for solving the above-mentioned problems and has an object to enable data compression processing using vector quantization to be carried out by hardware at a high speed.

Disclosure of the Invention

A data processing device of the present invention is a data processing device for outputting information indicative of a template pattern most similar to an input pattern among a plurality of template patterns prepared in advance, characterized by comprising first searching means for selecting template patterns to be subjected to calculation of the degree of similarity between the input pattern and the template patterns by the use of feature quantities of the input pattern and the template patterns upon searching the similar template pattern, and second searching means for performing the calculation in a bit serial fashion upon calculating the degree of similarity between the template patterns selected by the first searching means and the input pattern.

The data processing device of the present invention is further characterized in that the second searching means performs the calculation within a calculation unit time with respect to data inputted in a bit serial fashion and, based on a result of the calculation, judges per calculation unit time whether or not the degree of similarity is maximum.

The data processing device of the present invention is further characterized in that the first searching means reduces the number of the template patterns to be subjected to the calculation of the degree of similarity by the use of the feature quantities of the input pattern and the template patterns, and the second searching means performs the calculation of the degree of similarity between the input pattern and the template patterns selected by the first searching means in a bit serial fashion to thereby reduce the number of steps required for the calculation.

The data processing device of the present invention is further characterized in that each of the input pattern and the template patterns is one vector data composed of at least one element.

The data processing device of the present invention is further characterized in that each of the input pattern and the template patterns is composed of at least one element, the second searching means comprising similarity calculating means for calculating an absolute differential distance as the degree of similarity between the input pattern and each of the template patterns, the first searching means comprising similarity calculation judging means for judging, when an absolute value of a difference between the feature quantity of the input pattern and the feature quantity of a particular template pattern is not smaller than an absolute differential distance between the input pattern and a different template pattern different from the particular template pattern, not to perform calculation of an absolute differential distance between the different template pattern and the input pattern.

The data processing device of the present invention is further characterized in that the similarity calculating means is supplied with the template patterns selected by the first searching means and the input pattern both in a bit serial fashion from an upper digit of the data per calculation unit time, calculates the input data in a calculation unit time, and outputs an absolute differential distance as a result of the calculation in a bit serial fashion from an upper digit.

The data processing device of the present invention is further characterized in that the feature quantity is at least one of the sum of individual elements forming each of the input pattern and the template patterns, and the sum of the individual elements after a part of the individual elements have been inverted with respect to a reference value which is an intermediate value of possible values.

The data processing device of the present invention is further characterized in that the similarity calculating means is formed by a semiconductor circuit, the similarity calculating means being supplied with input data represented by a binary number system from an upper digit and producing output data represented by a redundant number system from an upper digit.

The data processing device of the present invention is further characterized in that the similarity calculating means comprises absolute differential value calculating means for calculating an absolute differential value between the elements of the input pattern and the template pattern per each element, and adding means for summing the absolute differential values for the respective elements calculated by the absolute differential value calculating means, the absolute differential value calculating means being equal in number to the elements of each pattern.

The data processing device of the present invention is further characterized in that the absolute differential value calculating means is supplied with input data in a binary number system from an upper digit, calculates differential values between the input data in a bit serial fashion, and outputs the differential values in a redundant number system from an upper digit..

The data processing device of the present invention is further characterized in that the absolute differential value calculating means further has a function of memorizing, as a state, a numerical value other than "0" that first appears in the differential value outputted in a bit serial fashion from the upper digit, inverting or non-inverting the differential value depending on the memorized state, and calculating the absolute differential value.

The data processing device of the present invention is further characterized in that the addition calculating section comprises delay means for giving a delay by a calculation unit time, the addition calculating section being supplied with input data in a redundant number system from an upper digit and outputting a calculation result in a redundant number system from an upper digit.

The data processing device of the present invention is further characterized in that the second searching means comprises holding means for holding a minimum absolute differential distance between the input pattern and the template pattern; and comparing means supplied with the minimum absolute differential distance held in the holing means in a bit serial fashion from an upper digit, and supplied with an absolute differential distance obtained by similarity calculating means in a bit serial fashion from an upper digit, the similarity calculating means being for calculating an absolute differential distance between a different template pattern different from the aforementioned template pattern and the input pattern, the comparing means being supplied with the absolute differential distances in the bit serial fashion from the upper digit and carrying out comparison in connection with the absolute differential distances; calculation for lower digits being stopped after it has been confirmed in the comparison by the comparing means that the absolute differential distance between the different template pattern different from the aforementioned template pattern and the input pattern is greater than the minimum absolute differential distance held in the holding means.

Brief Description of the Drawing

Fig. 1 is a block diagram showing one example of a data processing device according to a first embodiment.
Fig. 2 is a diagram for describing processing by a first search section.
Fig. 3 is a diagram showing another example of feature quantity extraction processing by the first search section.
Fig. 4 is a diagram showing one example of the feature quantity extraction processing in case where a plurality of inversion patterns are used.
Fig. 5 is a diagram showing a rate of actual calculation times when calculation of an absolute differential distance is carried out by using five kinds of inversion patterns.
Fig. 6 is a diagram showing one example of a circuit block for calculating the absolute differential distance.
Fig. 7 is a diagram exemplifying an absolute difference calculating section in the form of a circuit block.
Fig. 8 is a diagram exemplifying an addition calculating section in the form of a circuit block.
Fig. 9 is a diagram exemplifying, in the form of a circuit block, an addition calculating section wherein input data is increased to four in number.
Fig. 10 is a diagram showing truth tables of respective adders of the addition calculating section.
Fig. 11 is a diagram showing a state transition chart for finding out a minimum value.
Fig. 12 is a block diagram showing one example of a minimum value search calculating section.
Fig. 13 is a flow chart showing processing according to the first embodiment.
Fig. 14 is a flow chart showing the processing according to the first embodiment.
Fig. 15 is a diagram showing the rates of the number of times of performing calculation of an absolute differential distance in a second embodiment in case where five kinds of inversion patterns are used.

Best Mode for Carrying Out the Invention

Now, embodiments of the present invention will be described with reference to the drawing.

As a data processing device according to each embodiment of the present invention is illustrated in the form of a data processing device which performs vector quantization as one example of pattern matching processing. It is noted here that, when the degree of similarity is estimated by an absolute differential distance in the vector quantization, an operation of searching out a template vector most similar to an input vector corresponds to an operation of searching out a template vector giving a minimum absolute differential distance.

(First Embodiment)

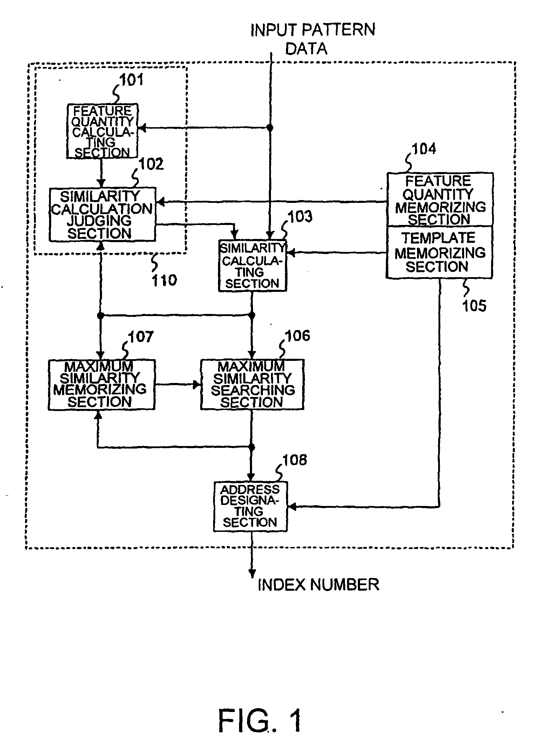

Fig. 1 is a block diagram showing one example of a data processing device according to a first embodiment of the present invention.

In Fig. 1, a first search section 110 is for carrying out processing of reducing the number of templates to be searched in pattern matching processing (vector quantization) and comprises a feature quantity calculating section 101 and a similarity calculation judging section 102. The feature quantity calculating section 101 calculates a feature quantity of an input vector by the use of the input vector. The similarity calculation judging section 102 judges whether or not similarity calculation (distance calculation) is to be executed, with reference to a feature quantity of a template vector memorized in a feature quantity memorizing section 104 and the feature quantity of the input vector calculated by the feature quantity calculating section 101.

Depending on the judgment result by the similarity calculation judging section 102, a similarity calculating section 103 performs the similarity calculation (distance catenation) between the input vector and the template vector. The feature quantity memorizing section 104 memorizes feature quantities of template vectors calculated in advance. A template memorizing section 105 memorizes a plurality of template vectors.

A maximum similarity searching section 106 compares the degree of similarity calculated by the similarity calculating section 103 and a maximum similarity obtained in the processing to the present and memorized in a maximum similarity memorizing section 107. After completion of the processing with respect to all the template vectors in the template memorizing section 105, an address designating section 108 outputs as an index an address of a particular template vector having the maximum similarity (most similar to the input vector) with reference to the comparison result in the maximum similarity searching section 106.

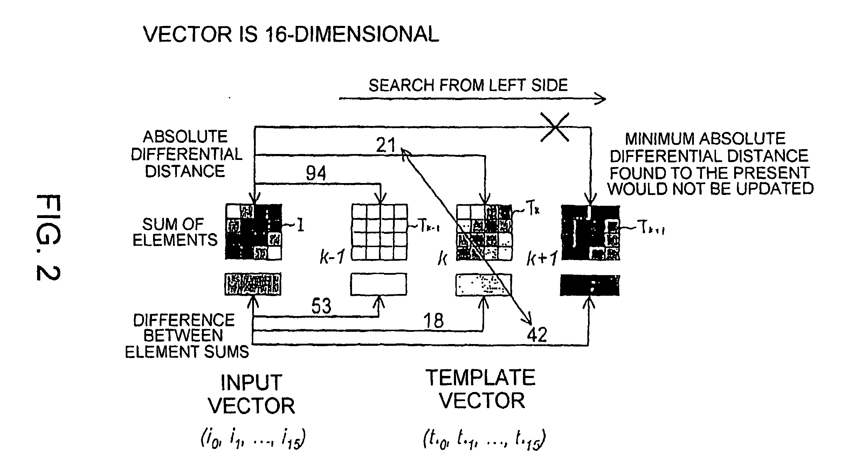

Fig. 2 is a diagram for describing the processing carried out by the first search section shown in Fig. 1. Referring to Fig. 2, description will be made about the processing in case where a total sum of elements (data values of respective pixels included in a block of a predetermined size, for example, $4 \times 4$ pixels) of each of the input vector and the template vectors is used as a feature quantity of each vector.

It is assumed here that each vector is n-dimensional. Then, the following relationship is established between a difference between sums of the elements in the input vector and sums of the elements in the template vector (right side of an expression (1) given below) and an absolute differential distance between the input vector and the template vector (left side of the expression (1) given below).

$$\sum_{l=0}^{n}\left|t_{kl} - i_l\right| \geq \left|\sum_{l=0}^{n}t_{kl} - \sum_{l=0}^{n}i_l\right| \quad \dots \quad (1)$$

In the expression (1), $i_l$ represents an *l*-th element of an input vector I and $t_{kl}$ represents an *l*-th element of a k-th template vector $T_k$.

The expression (1) represents that an absolute differential distance between two vectors is equal to or greater than an absolute value of a difference between the respective sums of the elements in those vectors. Thus, a method using the expression (1) is a method of extracting and using a density in a whole block as a feature quantity.

Hereinafter, description will be made about a codebook searching procedure in the vector quantization using the relationship given by the expression (1), in which a template vector most similar to the input vector is found out from a codebook composed of a plurality of template vectors.

(Step 1) The total sum of elements in each template vector is calculated for all template vectors and memorized in the feature quantity memorizing section 104 in advance.

(Step 2) When the input vector I is given, a total sum of elements in the input vector I is calculated by the feature quantity calculating section 101. Then, an absolute differential distance between the first template vector $T_1$ and the input vector I is calculated by the similarity calculating section 103 and memorized in the maximum similarity memorizing section 107 as a minimum absolute differential distance.

(Step 3) Then, a difference between a total sum of elements in the second template vector $T_2$ and a total sum of the elements in the input vector I is calculated by the similarity calculation judging section 102. Further, the similarity calculation judging section 102 compares the calculated difference between the total element sums with the minimum absolute differential distance memorized in the maximum similarity memorizing section 107.

In case where, as a result of the above-mentioned comparison, the difference between the total element sums in both vectors is smaller than or equal to the minimum absolute differential distance, the similarity calculation judging section 102 judges that similarity calculation has to be carried out in the similarity calculating section 103. Following the above-mentioned judgment, the similarity calculating section 103 calculates an absolute differential distance between the template vector $T_2$ and the input vector I.

The maximum similarity searching section 106 compares the absolute differential distance calculated by the similarity calculating section 103 and the minimum absolute differential distance. In case where, as a result of the comparison, the absolute differential distance calculated by the similarity calculating section 103 is smaller than the minimum absolute differential distance, an index of the template vector is stored. The absolute differential distance calculated by the similarity calculating section 103 is memorized in the maximum similarity memorizing section 107 as an updated minimum absolute differential distance to update the minimum absolute differential distance.

On the other hand, in case where the difference between the element sums is greater than the minimum absolute differential distance as a result of the comparison in the similarity calculation judging section 102, an absolute differential distance between the template vector and the input vector would not update the minimum absolute differential distance (become smaller than the minimum absolute differential distance). Therefore, the similarity calculation judging section 102 judges not to carry out similarity calculation in the similarity calculating section 103. Then, searching a next template vector is started without performing calculation of the absolute differential distance.

(Step 4) Subsequently, the step 3 is repeated to the last of all the template vectors memorized in the template memorizing section 105.

By performing the processing as described above, the first search section selects those template vectors to be searched (to be subjected to matching) with reference to the feature quantities. Thus, it is possible to reduce the number of times of matching between the input vector and the template vectors. Herein, calculation for obtaining the difference between the total sum of elements can be simply carried out with respect to all the template vectors but because of one-dimensional scalar calculation. On the other hand, calculation of the absolute differential distances can be realized by n-dimensional vector calculation. Accordingly, when $n \geqq 2$, a large amount of n-dimensional vector calculation can be omitted by using simple scalar calculation so that the calculation amount can be decreased.

For example, as shown in Fig. 2, it is assumed that a difference between a total sum of the elements in the input vector I and a total sum of the elements in the (k-1)-th template vector $T_{k-1}$ is equal to "53" and that an absolute differential distance between the input vector I and the template vector $T_{k-1}$ is equal to "94" (which is supposed in Fig. 2 to be a minimum absolute differential distance among the first to the (k-1)-th template vectors).

In this event, a difference between the total sum of the elements in the input vector I and a total sum of elements in the following k-th template vector $T_k$ is equal to "18" which is smaller than the absolute differential distance "94" between the input vector I and the template vector $T_{k-1}$ as the minimum absolute differential distance. Therefore, calculation is carried out about an absolute differential distance between the input vector I and the following template vector $T_k$. The calculation gives an absolute differential distance of "21" which is smaller than the previous minimum absolute differential distance. Therefore, the minimum absolute differential distance is updated to "21".

Next, a difference between the total sum of the elements in the input vector I and a total sum of elements in the next following (k+1)-th template vector $T_{k+1}$ is equal to "42" and is greater than the minimum absolute differential distance "21" between the input vector I and the template vector $T_{k+1}$ which is kept as the minimum absolute differential distance. Therefore, an absolute differential distance between the input vector I and the template vector $T_{k+1}$ may not be calculated. Thus, with respect to the template vector $T_{k+1}$, only the simple one-dimensional scalar calculation is carried out while the n-dimensional vector calculation is not carried out. Then, the processing proceeds to the next template vector.

Although a total sum of the elements in each vector is used as the feature quantity in the foregoing example, the feature quantity is not limited thereto.

For example, it is possible to use, as the feature quantity, a difference between total sums of elements in the input vector and the template vector both of which are inverted, as will be described hereinbelow. An inequality in an expression (2) holds between an absolute differential distance between the input vector and the template vector and a difference between total sums of elements in the respective vectors after inversion.

$$\sum_{l=0}^{n}\left|t_{kl} - i_l\right| \geq \left| \left\{\sum_{l=0}^{m} t_{kl} + \sum_{l=m+1}^{n}(255 - t_{kl})\right\} - \left\{\sum_{l=0}^{m} i_l + \sum_{l=m+1}^{n}(255 - i_l)\right\} \right| \quad (n > m)$$

$$\cdots\cdots (2)$$

The expression (2) shows a case where a data value of each pixel falls within the range of "0" to "255" by way of example.

Herein, "inversion" means that the data values are subjected to white-black inversion with respect to an intermediate value as the center. For example, in case where a data value of each pixel falls within the range of "0" to "255", the center value is equal to "127.5". Therefore, a data value "128" is inverted into "127" and a data value "100" is inverted into "155". In an example described hereinbelow, inversion is carried out by subtracting from "255" a data value of a pixel to be inverted.

Further, the inversion is not carried out with respect to all the pixels but the pixels are partly inverted. In the expression (2), 0-th to m-th pixels are noninverted while (m+1)-th to n-th pixels are inverted. It is noted here that those pixels to be inverted need not be consecutively numbered. However, those pixels to be inverted should be common to the input vector and the template vector in element numbers.

The method using the expression (2) is a method of extracting and using a feature which appears in a direction of a luminance change in a block.

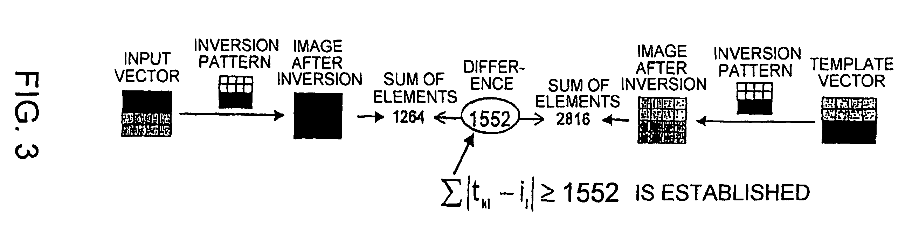

Fig. 3 shows an example of feature quantity extraction for utilizing the relationship given in the expression (2). In the feature quantity extraction for utilizing the relationship given in the expression (2), a particular inversion pattern is prepared in advance. In Fig. 3, the inversion pattern is represented by two values of "white" and "black". A "white" portion indicates non-inversion while a "black" portion indicates inversion.

First, the feature quantity calculating section 101 inverts those pixels of the input vector corresponding to inversion by using the inversion pattern and calculates a total sum of elements after the inversion. For the template vector also, inversion is carried out by using the similar inversion pattern and a total sum of elements is calculated and memorized in the feature quantity memorizing section 104.

Then, the similarity calculation judging section 102 calculates a difference between the thus obtained total sum of the elements in the input vector after the inversion and the thus obtained total sum of the elements in the template vector after the inversion. In the example shown in Fig. 3, the difference between the total sums of elements in the input and the template vectors is equal to "1552". In this event, an absolute differential distance between the input vector and the template vector invariably takes a value equal to or greater than "1552" from the above-mentioned expression (2). By utilizing the relationship represented by the inequality given by the above-mentioned expression (2), in case where the difference between the total sums of the elements in the vectors after the inversion is greater than the minimum absolute differential distance obtained in the processing to the present, search (distance calculation) of a following template vector is judged unnecessary and the calculation can be omitted.

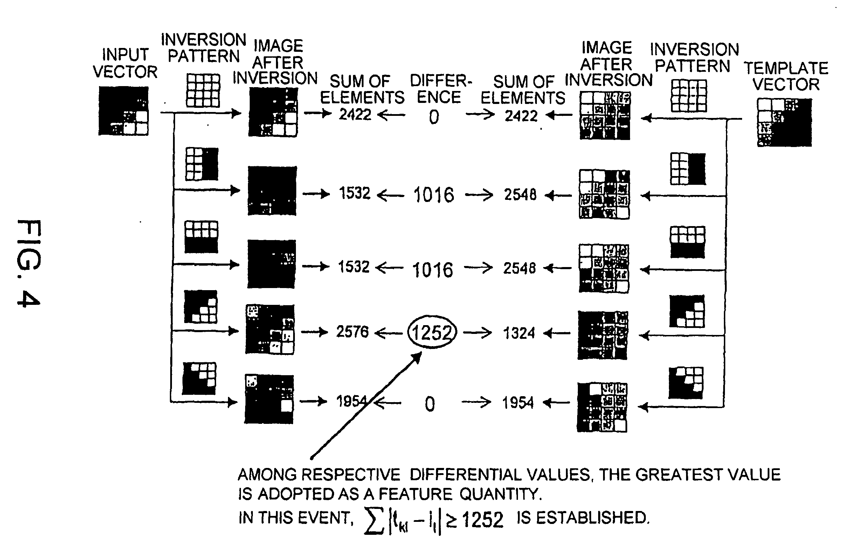

Although only one kind of inversion pattern is used in the example shown in Fig. 3, it is also possible to use a plurality of kinds of inversion patterns. Fig. 4 shows an example of using a plurality of (five kinds of) inversion patterns. Also in Fig. 4, each inversion pattern is represented by two values of "white" and "black". The "white" portion indicates non-inversion while the "black" portion indicates inversion.

Like in the example shown in Fig. 3, an input vector and a template vector are inverted by using the respective inversion patterns. A difference between a total sum of elements in each input vector after the inversion and a total sum of elements in each template vector after the inversion is obtained with respect to each inversion pattern. Herein, an absolute differential distance between the input vector and the template vector is equal to or greater than the difference between the total sum of the elements, according to the expression (2). Therefore, the maximum value among the differences between the total sums of the elements in the respective inversion patterns is obtained and adopted as a feature quantity.

In the example shown in Fig. 4, the maximum value of the difference between the total sum of the elements in the input vectors after the inversion and the total sum of the elements in the template vectors after the inversion is equal to "1252". In this event, the absolute differential distance between the input vector and the template vector invariably takes a value equal to or greater than "1252".

Thus, by increasing the number of the inversion patterns used for the feature quantity extraction, the calculation amount can further be reduced.

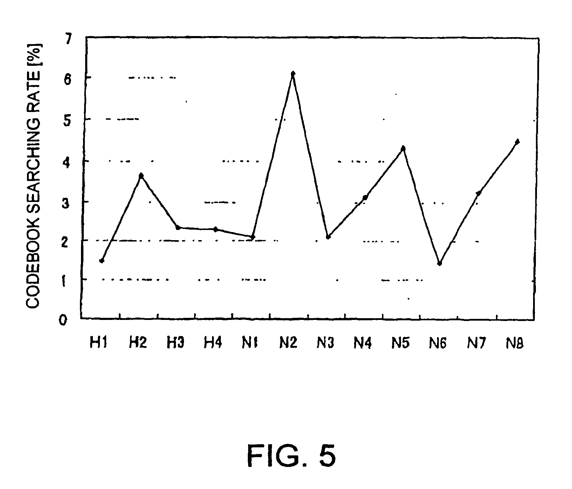

Fig. 5 is a diagram showing the rates of the number of calculation times of the absolute differential distance between an input vector and template vectors when vector quantization is carried out with respect to twelve kinds of still images by the use of five kinds of inversion patterns. In Fig. 5, a codebook searching rate represents, in percentage, the number of the template vectors used in calculating the absolute differential distance, relative to a total number of the template vectors memorized in the template memorizing section 105. In the example shown in Fig. 5, the size of a codebook (the total number of the template vectors memorized in the template memorizing section 105) is equal to 2048. As shown in Fig. 5, it is sufficient to carry out the calculation of the absolute differential distances between the input vector and the template vectors with respect to only 2 to 7% of the total number of the template vectors prepared in advance. Therefore, it is possible to significantly shorten a time required for vector quantization and to speed up the data compression processing using the vector quantization.

In the above-mentioned searching method using the feature quantities, the mathematical relationship is used which is established between the two vectors (the input vector and the template vector). Therefore, it is possible to omit or reduce an amount of calculation without causing decrease in accuracy.

Next, description will be made about second-stage processing for reducing the number of calculation cycles upon performing calculation of the degree of similarity of patterns.

In the vector quantization, the degree of similarity is given by the absolute differential distance. The calculation of the degree of similarity, i.e. the absolute differential distance, is carried out in the similarity calculating section 103 shown in Fig. 1.

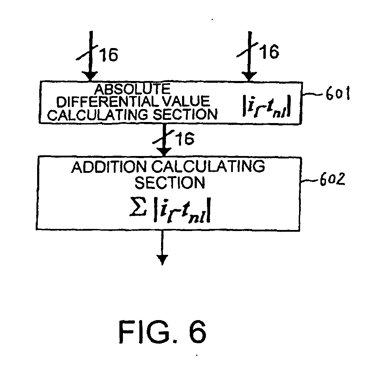

Fig. 6 shows one example of a circuit block diagram for calculating the absolute differential distance. In Fig. 6, 601 denotes an absolute differential value calculating section that calculates an absolute differential distance between vectors element by element. 602 denotes an addition calculating section that calculates the sum of the absolute differential distances for the respective elements calculated by the absolute differential value calculating section 601. In Fig. 6, each of the vectors (the input vector and the template vector) is 16-dimensional. However, the present invention is not limited thereto and the number of dimensions may be increased.

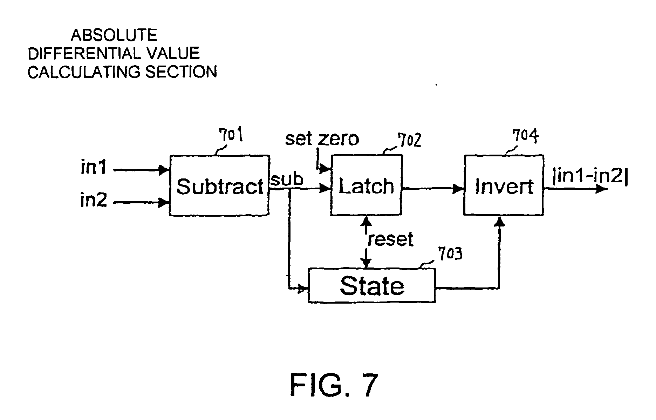

Fig. 7 is a diagram showing one example of the absolute differential value calculating section 601 shown in Fig. 6, in the form of a circuit block. The absolute differential value calculating section 601 shown in Fig. 7 is supplied with input data in a bit serial fashion from an upper digit, performs calculation in a calculation unit time, and outputs an absolute differential value as a result of calculation from an upper digit. The absolute differential value calculating section is supplied with binary data and outputs a result in an SD (Signed Digit) number system of a binary-coded ternary notation. Here, the SD number system of binary-coded ternary notation is a number system allowing a code set, such as "-1, 0, 1" at each digit. For example, "2" in decimal number can be expressed as "0010", "01-10", "1-1-10", or the like (with weights of $2^3$, $2^2$, $2^1$, and $2^0$ from the upper digit) in the SD number system of the binary-coded ternary notation.

The absolute differential value calculating section comprises two blocks, i.e. a block for performing difference calculation and another block for performing absolute value calculation. The difference calculation block 701 carries out subtraction per digit from the upper digit and outputs a result of the subtraction per digit. The subtraction result is latched by a temporary storage register 702 and supplied to a state control block 703. The state control block 703 is a state machine that checks the subtraction result from the upper digit and sends a sign inversion request signal to a signal inversion block if a number other than "0" that first appears is negative.

When the sign inversion request signal is outputted from the state control block 703, a differential value is negative. Therefore, an absolute value calculation block 704 carries out inversion to obtain an absolute value. On the other hand, when the sign inversion request signal is not outputted, a differential value is "0" or positive. Therefore, data is outputted without any inversion (as it is). By providing a plurality of the absolute differential value calculating sections shown in Fig. 7 in parallel as many as the number of dimensions of the vector, it is possible to input 16 elements of each of the input vector and the template vector in a bit serial fashion from the upper digit, to perform calculation in a calculation unit time, and to output absolute differential values as calculation results in a bit serial fashion from the upper digit

Next, all the absolute differential values outputted by the absolute differential value calculating section 601 from the upper digit are summed by the addition calculating section from the upper digit. Thus, an absolute differential distance is calculated. In order to carry out the addition from the upper digit, the SD number system of the binary-coded ternary notation is used. Using the SD number system of the binary-coded ternary notation provides such a characteristic that propagation of a carry signal in the addition calculation is limited to two digits at maximum. Utilizing this characteristic, the calculation is executed with reference to a first lower digit and a second lower digit. Thus, it is possible to perform the addition calculation from the upper digit.

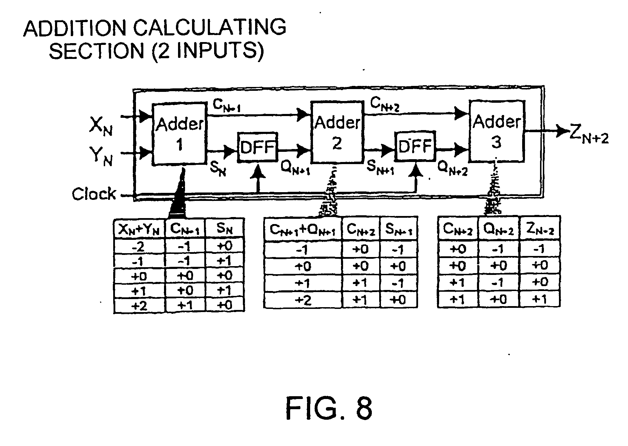

Fig. 8 is a diagram showing one example of the addition calculating section shown in Fig. 6 in the form of a circuit block.

The addition calculating section shown in Fig. 8 is supplied with data from the upper digit, performs calculation in a calculation unit time, and outputs data from the upper digit. In the addition calculation using the SD number system of the binary-coded ternary notation, a carry signal propagates up to two digits. Therefore, use is made of a structure including two delay elements in order to refer to information of lower two digits. In Fig. 8, $X_N$ and $Y_N$ are input data while $Z_{N+2}$ is output data.

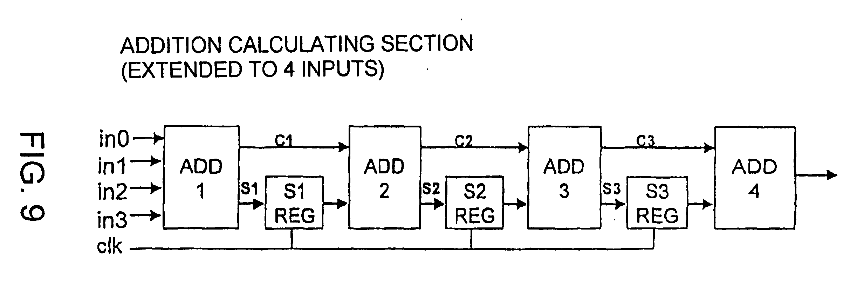

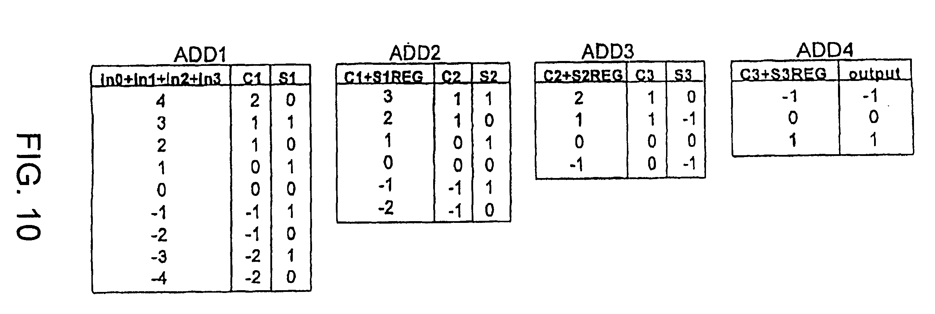

Although the data inputted is equal in number to two in the addition calculation section shown in Fig. 8, the number of inputs may be increased. Fig. 9 is a diagram showing one example of circuit blocks of an addition calculating section with the number of input data increased to four. Each adder may be designed to satisfy truth tables shown in Fig. 10, respectively. This applies to an adding calculating section and an absolute value calculating section both of which are extended to sixteen and which enables calculation of an absolute differential distance between two vectors of sixteen dimensions from an upper digit. In the SD number system of the binary-coded ternary notation, a negative number of a value can be expressed by representing a single digit by several bits and may be therefore designed in a desired manner.

Next, the maximum similarity searching section 106 will be described.

A "large" or "small" relationship between numbers of the SD number system of the binary-coded ternary notation can be determined at a time instant when a difference of "2" or more appears at a certain digit or its upper digit while numerical values are being checked from the upper digit. It is assumed that, with respect to two particular numbers, one of the numbers is greater by "2" at an m-th or upper digit, this number is greater than the other number.

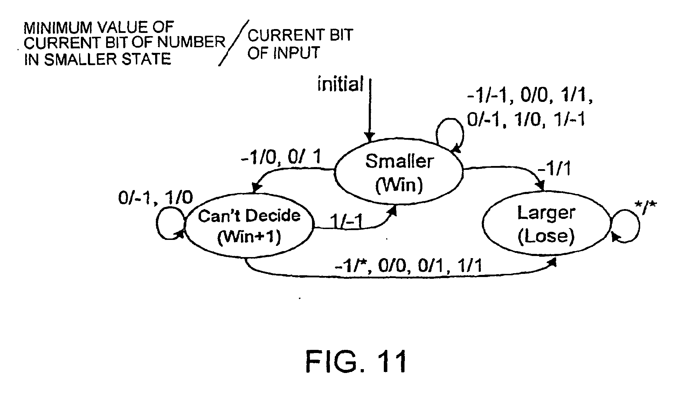

In order to find out a minimum value from many numerical values inputted in a serial fashion from the upper digit, three states are defined. Upon reception of a particular digit, a numerical value judged to be greater than a numerical value supposed to be minimum is defined as "Larger". A numerical value greater than the minimum by one is defined as "Can't Decide". A numerical value supposed to be the minimum is defined as "Smaller". Then, a circuit is designed on the basis of a state transition chart shown in Fig. 11. A numerical value remaining in the "Smaller" state when data have been inputted to the last is the minimum value (Winner).

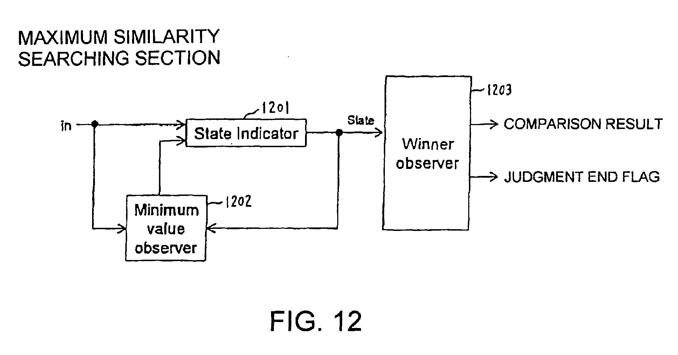

Fig. 12 shows a minimum value search calculating section based on the above-mentioned principle. A sequential circuit 1201 for temporarily holding a state according to the state transition chart is specified by a "State Indicator". A circuit 1202 for calculating a minimum value of a current digit of a number in the "Smaller" state is specified by a "Minimum value observer". A circuit 1203 for encoding a position of the "Winner" is specified by a "Winner observer". With the above-mentioned circuit structure, the number of inputs can be freely increased by providing "State Indicators" 1201 for the respective inputs.

The "State Indicator" 1201 is reset into the "Smaller" state as an initial state. Data to be compared is inputted in a serial fashion from the upper digit. At a time instant when one is in the "Smaller" state while all the others are in the "Larger" state, the "Winner observer" block 1203 outputs a comparison result and a judgment end flag.

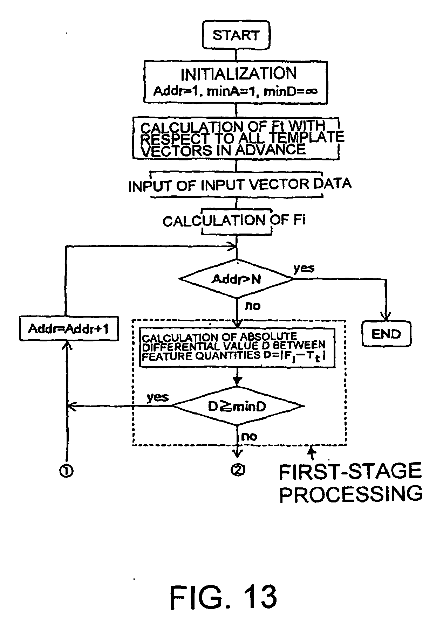

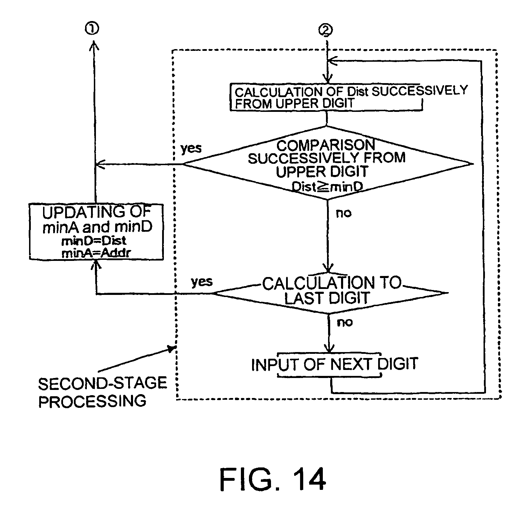

Summarizing the processing described above, the processing in this embodiment is realized according to a flow chart shown in Figs. 13 and 14.

In Figs. 13 and 14, Addr represents an address of each template vector, N represents the total number of template vectors, minA represents an address of a candidate template vector as a candidate to be searched, minD represents a minimum absolute differential distance, Fi represents a feature quantity of an input vector, Ft represents a feature quantity of each template vector, D represents an absolute differential value between the feature quantities, and Dist represents an absolute differential distance which is being calculated.

(Second Embodiment)

Next, a second embodiment will be described.
As one method of vector quantization, there is a method of removing mean values of blocks as a process prior to pattern matching.
Hereinbelow, description will be made about one example of the method of removing the mean values of the blocks.
As shown in expressions (3) and (4), a certain vector X is divided into its mean value m and a remainder or remnant R left after the mean value m is removed. Pattern matching is carried out using the remainder R as a new vector.

$$m = \frac{1}{k}\sum_{i=1}^{k} Xi \quad \dots \quad (3)$$

$$Ri = Xi - m \qquad (4)$$

However, removing the mean value information of the blocks results in unifying mean values among all the blocks so that variation in mean value information becomes small. Here, the method of reducing the calculation amount utilizing the relationship given in the expression (1) is a method utilizing that variation in mean value information of the vectors is large and, therefore, does not work effectively when the variation in mean value information of the vectors is equalized.
However, even if the mean values are removed, the information related to a variation of luminance of the blocks is not lost. Therefore, the method of reducing the calculation amount utilizing the relationship given in the expression (2) is effective.

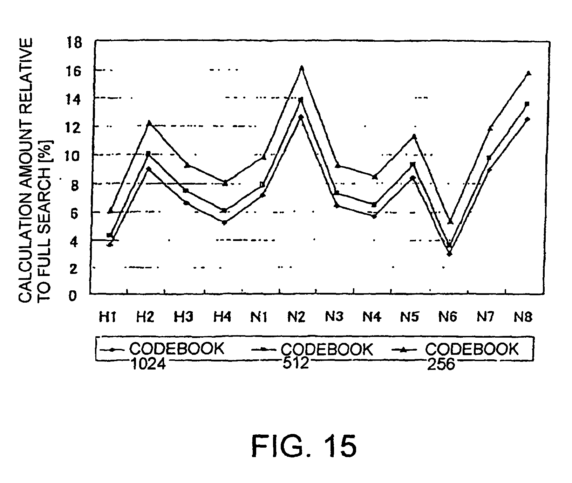

Fig. 15 is a graph showing the rates of performing calculation of absolute differential distances when vector quantization is carried out with respect to the twelve kinds of still images, by the use of the five kinds of inversion patterns in the block whose mean value information is removed, by the use of the calculation reducing method according to the first embodiment. In Fig. 13, use is made of codebooks having three kinds of sizes.

(Effect of the Invention)

As described above, according to the present invention, in pattern matching processing in vector quantization used in, for example, data compression processing of image data or sound data, it is possible to reduce the number of templates required to be subjected to matching, by utilizing feature quantities of an input pattern and template patterns. Further, by performing calculation upon matching from the upper digit, it is possible to reduce the number of cycles of the calculation. Thus, by combining the two kinds of calculation skipping processing, a high calculation skipping rate can be achieved and the data compression processing using the vector quantization can be carried out at a high speed.
Further, in case where a method of removing information about mean values of blocks is used in the vector quantization, it is possible to reduce the number of the templates required to be subjected to matching by the use of a plurality of kinds of feature quantities.

Industrial Applicability

The present invention is applicable to a communication system in which image or sound data is compressed at a high speed and transmitted, a transmission device used in the system, and so forth. In the foregoing embodiment, the description has been made on the assumption that the data processing device shown in Fig. 1, particularly, the first search section for calculating the degree of similarity, is formed by a semiconductor circuit. However, the present invention is not limited thereto at all, but may be implemented by a CPU that executes a program defining operations of the data processing device. Further, the processing shown in Figs. 13 and 14 may be realized by a computer program.

In the foregoing, the description has been made only about the illustrative embodiments of the present invention. However, it will readily be understood by a person skilled in the art that the embodiments can be modified and changed in various manners without significantly departing from the novel structure and effect of the present invention. Therefore, all of those modifications and changes are covered by the scope of the present invention.

**Claims**

1. A data processing device for outputting information indicative of a template pattern most similar to an input pattern among a plurality of template patterns prepared in advance, **characterized by** comprising first searching means for selecting template patterns to be subjected to calculation of the degree of similarity between said input pattern and said template patterns by the use of feature quantities of said input pattern and said template patterns upon searching the similar template pattern, and second searching means for performing the calculation in a bit serial fashion upon calculating the degree of similarity between the template patterns selected by said first searching means and said input pattern.

2. A data processing device according to claim 1, **characterized in that** said second searching means performs the calculation within a calculation unit time with respect to data inputted in a bit serial fashion and, based on a result of the calculation, judges per calculation unit time whether or not the degree of similarity is maximum.

3. A data processing device according to claim 1, **characterized in that** said first searching means reduces the number of the template patterns to be subjected to the calculation of the degree of similarity by the use of the feature quantities of said input pattern and said template patterns, and said second searching means performs the calculation of the degree of similarity between said input pattern and the template patterns selected by said first searching means in a bit serial fashion to thereby reduce the number of steps required for said calculation.

4. A data processing device according to claim 1, **characterized in that** each of said input pattern and said template patterns is one vector data composed of at least one element.

5. A data processing device according to claim 1, **characterized in that** each of said input pattern and said template patterns is composed of at least one element, said second searching means comprising similarity calculating means for calculating an absolute differential distance as the degree of similarity between said input pattern and each of said template patterns, said first searching means comprising similarity calculation judging means for judging, when an absolute value of a difference between the feature quantity of the input pattern and the feature quantity of a particular template pattern is not smaller than an absolute differential distance between the input pattern and a different template pattern different from the particular template pattern, not to perform calculation of an absolute differential distance between the different template pattern and said input pattern.

6. A data processing device according to claim 5, **characterized in that** said similarity calculating means is supplied with the template patterns selected by said first searching means and the input pattern both in a bit serial fashion from an upper digit of the data per calculation unit time, calculates said input data in a calculation unit time, and outputs an absolute differential distance as a result of the calculation in a bit serial fashion from an upper digit.

7. A data processing device according to claim 1, **characterized in that** said feature quantity is at least one of the sum of individual elements forming each of said input pattern and said template patterns, and the sum of the individual elements after a part of said individual elements have been inverted with respect to a reference value which is an intermediate value of possible values.

8. A data processing device according to claim 5, **characterized in that** said similarity calculating means is formed by a semiconductor circuit, said similarity calculating means being supplied with input data represented by a binary number system from an upper digit and producing output data represented by a redundant number system from an upper digit.

9. A data processing device according to claim 5, **characterized in that** said similarity calculating means comprises absolute differential value calculating means for calculating an absolute differential value between the elements of the input pattern and the template pattern per each element, and adding means for summing the absolute differential values for the respective elements calculated by said absolute differential value calculating means, said absolute differential value calculating means being equal in number to the elements of each pattern.

10. A data processing device according to claim 8, **characterized in that** said absolute differential value calculating means is supplied with input data in a binary number system from an upper digit, calculates differential values between the input data in a bit serial fashion, and outputs the differential values in a redundant number system from an upper digit.

11. A data processing device according to claim 10, **characterized in that** said absolute differential value calculating means further has a function of memorizing, as a state, a numerical value other than "0" that first appears in the differential value outputted in a bit serial fashion from the upper digit, inverting or non-inverting the differential value depending on said memorized state, and calculating the absolute differential value.

12. A data processing device according to claim 10, **characterized in that** said addition calculating section comprises delay means for giving a delay by a calculation unit time, said addition calculating section being supplied with input data in a redundant number system from an upper digit and outputting a calculation result in a redundant number system from an upper digit.

13. A data processing device according to claim 1, **characterized in that** said second searching means comprises:

holding means for holding a minimum absolute differential distance between the input pattern and the template pattern; and

comparing means supplied with the minimum absolute differential distance held in said holing means in a bit serial fashion from an upper digit, and supplied with an absolute differential distance obtained by similarity calculating means in a bit serial fashion from an upper digit, said similarity calculating means being for calculating an absolute differential distance between a different template pattern different from the aforementioned template pattern and the input pattern, said comparing means being supplied with the absolute differential distances in the bit serial fashion from the upper digit and carrying out comparison in connection with the absolute differential distances;

calculation for lower digits being stopped after it has been confirmed in the comparison by said comparing means that the absolute differential distance between the different template pattern different from said aforementioned template pattern and the input pattern is greater than the minimum absolute differential distance held in said holding means.

14. A data processing method of comparing an input vector composed of a plurality of elements and template vectors each composed of a plurality of elements and prepared in advance to thereby determine the most similar template vector, **characterized by** comprising:

a step of performing scalar calculation with respect to the elements of said template vector to obtain a first calculation result;

a step of receiving said input vector and performing scalar calculation with respect to the elements of said input vector to obtain a second calculation result;

a step of calculating an absolute differential value between said first and said second calculation results as a first absolute differential value;

a step of performing vector calculation of said template vector and said input vector to calculate a second absolute differential value as a vector calculation result; and

a step of determining said most similar template vector by utilizing the fact that said first absolute differential value does not exceed said second absolute differential value.

15. A computer-readable program used for comparing an input vector composed of a plurality of elements and template vectors each composed of a plurality of elements and prepared in advance to thereby determine the most similar template vector, **characterized by** comprising:

a step of performing scalar calculation with respect to the elements of said template vector to obtain a first calculation result;

a step of receiving said input vector and performing scalar calculation with respect to the elements of said input vector to obtain a second calculation result;

a step of calculating an absolute differential value between said first and said second calculation results as a first absolute differential value;

a step of performing vector calculation of said template vector and said input vector to calculate a second absolute differential value as a vector calculation result; and

a step of determining said most similar template vector by utilizing the fact that said first absolute differential value does not exceed said second absolute differential value.

INPUT PATTERN
DATA

101

FEATURE
QUANTITY
CALCULA-
TING
SECTION

102

SIMILARITY
CALCULATION
JUDGING
SECTION

110

103

SIMILARITY
CALCULA-
TING
SECTION

104

FEATURE
QUANTITY
MEMORIZING
SECTION

TEMPLATE
MEMORIZING
SECTION

105

107

MAXIMUM
SIMILARITY
MEMORIZING
SECTION

106

MAXIMUM
SIMILARITY
SEARCHING
SECTION

108

ADDRESS
DESIGNA-
TING
SECTION

INDEX NUMBER

# FIG. 1

VECTOR IS 16-DIMENSIONAL

SEARCH FROM LEFT SIDE →

MINIMUM ABSOLUTE DIFFERENTIAL DISTANCE FOUND TO THE PRESENT WOULD NOT BE UPDATED

ABSOLUTE DIFFERENTIAL DISTANCE

SUM OF ELEMENTS

DIFFERENCE BETWEEN ELEMENT SUMS

INPUT VECTOR

$(i_0, i_1, ..., i_{15})$

TEMPLATE VECTOR

$(t_0, t_1, ..., t_{15})$

94

21

18

53

42

$T_{k-1}$

$T_k$

$T_{k+1}$

$k-1$

$k$

$k+1$

I

# FIG. 2

**FIG. 3**

INPUT VECTOR → INVERSION PATTERN → IMAGE AFTER INVERSION → SUM OF ELEMENTS 1264

DIFFERENCE 1552

SUM OF ELEMENTS 2816 ← IMAGE AFTER INVERSION ← INVERSION PATTERN ← TEMPLATE VECTOR

$$\sum \left| t_{kl} - i_i \right| \geq 1552 \quad \text{IS ESTABLISHED}$$

EP 1 487 112 A1

# FIG. 4

AMONG RESPECTIVE DIFFERENTIAL VALUES, THE GREATEST VALUE
IS ADOPTED AS A FEATURE QUANTITY.

IN THIS EVENT, $\sum |t_{kl} - i_l| \geq 1252$ IS ESTABLISHED.

FIG. 5

**FIG. 6**

ABSOLUTE
DIFFERENTIAL VALUE
CALCULATING SECTION

FIG. 7

## ADDITION CALCULATING SECTION (2 INPUTS)

| $X_N+Y_N$ | $C_{N-1}$ | $S_N$ |
|---|---|---|
| -2 | -1 | +0 |
| -1 | -1 | +1 |
| +0 | +0 | +0 |
| +1 | +0 | +1 |
| +2 | +1 | +0 |

| $C_{N+1}+Q_{N+1}$ | $C_{N+2}$ | $S_{N+1}$ |
|---|---|---|
| -1 | +0 | -1 |
| +0 | +0 | +0 |
| +1 | +1 | -1 |
| +2 | +1 | +0 |

| $C_{N+2}$ | $Q_{N-2}$ | $Z_{N-2}$ |
|---|---|---|
| +0 | -1 | -1 |
| +0 | +0 | +0 |
| +1 | -1 | +0 |
| +1 | +0 | +1 |

# FIG. 8

ADDITION CALCULATING SECTION
(EXTENDED TO 4 INPUTS)

FIG. 9

**ADD1**

| In0+In1+In2+In3 | C1 | S1 |
|---|---|---|
| 4 | 2 | 0 |
| 3 | 1 | 1 |
| 2 | 1 | 0 |
| 1 | 0 | 1 |
| 0 | 0 | 0 |
| -1 | -1 | 1 |
| -2 | -1 | 0 |
| -3 | -2 | 1 |
| -4 | -2 | 0 |

**ADD2**

| C1+S1REG | C2 | S2 |
|---|---|---|
| 3 | 1 | 1 |
| 2 | 1 | 0 |
| 1 | 0 | 1 |
| 0 | 0 | 0 |
| -1 | -1 | 1 |
| -2 | -1 | 0 |

**ADD3**

| C2+S2REG | C3 | S3 |
|---|---|---|
| 2 | 1 | 0 |
| 1 | 1 | -1 |
| 0 | 0 | 0 |
| -1 | 0 | -1 |

**ADD4**

| C3+S3REG | output |
|---|---|
| -1 | -1 |
| 0 | 0 |
| 1 | 1 |

FIG. 10

MINIMUM VALUE OF
CURRENT BIT OF NUMBER / CURRENT BIT
IN SMALLER STATE / OF INPUT

initial

-1/-1, 0/0, 1/1,
0/-1, 1/0, 1/-1

-1/0, 0/ 1

Smaller
(Win)

-1/1

0/-1, 1/0

Can't Decide
(Win+1)

1/-1

Larger
(Lose)

*/*

-1/*, 0/0, 0/1, 1/1

## FIG. 11

MAXIMUM SIMILARITY
SEARCHING SECTION

FIG. 12

START

INITIALIZATION
Addr=1, minA=1, minD=∞

CALCULATION OF Fi WITH
RESPECT TO ALL TEMPLATE
VECTORS IN ADVANCE

INPUT OF INPUT VECTOR DATA

CALCULATION OF Fi

Addr>N

yes

no

Addr=Addr+1

CALCULATION OF ABSOLUTE
DIFFERENTIAL VALUE D BETWEEN
FEATURE QUANTITIES $D=|F_i - T_t|$

END

$D \geq minD$

yes

no

①     ②

FIRST-STAGE
PROCESSING

FIG. 13

①             ②

CALCULATION OF Dist SUCCESSIVELY
FROM UPPER DIGIT

COMPARISON
SUCCESSIVELY FROM
UPPER DIGIT
$Dist \geqq minD$

yes

no

UPDATING OF
minA and minD
minD=Dist
minA=Addr

CALCULATION TO
LAST DIGIT

yes

no

INPUT OF NEXT DIGIT

SECOND-STAGE
PROCESSING

# FIG. 14

FIG. 15

## INTERNATIONAL SEARCH REPORT

| | |
|---|---|
| International application No. | |
| | PCT/JP03/01629 |

**A. CLASSIFICATION OF SUBJECT MATTER**
Int.Cl$^7$ H03M7/30, H04N7/28

According to International Patent Classification (IPC) or to both national classification and IPC

**B. FIELDS SEARCHED**

Minimum documentation searched (classification system followed by classification symbols)
Int.Cl$^7$ H03M7/30, H04N7/28

Documentation searched other than minimum documentation to the extent that such documents are included in the fields searched
Jitsuyo Shinan Koho(Y1, Y2)　1926–1996　Toroku Jitsuyo Shinan Koho(U)　1994–2003
Kokai Jitsuyo Shinan Koho(U)　1971–2003　Jitsuyo Shinan Toroku Koho(Y2)　1996–2003

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 11-289459 A (Matsushita Electric Industrial Co., Ltd.), 19 October, 1999 (19.10.99), Fig. 1 (Family: none) | 1-15 |
| A | JP 2000-004164 A (Tadahiro OMI et al.), 07 January, 2000 (07.01.00), Fig. 1 (Family: none) | 1-15 |
| A | JP 2001-204024 A (Tadahiro OMI et al.), 27 July, 2001 (27.07.01), Fig. 1 (Family: none) | 1-15 |

| ☐ Further documents are listed in the continuation of Box C. | ☐ See patent family annex. |
|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 20 May, 2003 (20.05.03) | 03 June, 2003 (03.06.03), |

| Name and mailing address of the ISA/ | Authorized officer |
|---|---|
| Japanese Patent Office | |
| Facsimile No. | Telephone No. |

Form PCT/ISA/210 (second sheet) (July 1998)